# EUROPEAN PATENT APPLICATION

(11) **EP 2 690 667 A1**
(43) Date of publication of application: **29.01.2014**
(21) Application number: 12764781.6
(22) Date of filing: 09.03.2012
(51) Int. Cl.: H01L 31/04

(54) **METHOD FOR PRODUCING PHOTOELECTRIC CONVERSION DEVICE**

(30) Priority: 25.03.2011 JP 2011068313
(71) Applicant: Sanyo Electric Co., Ltd., Osaka 570-8677 (JP)
(72) Inventor: GOTO, Ryo, Chuo-ku, Osaka 540-6207 (JP); SHIMADA, Satoru, Chuo-ku, Osaka 540-6207 (JP); SHIGEMATSU, Masato, Chuo-ku, Osaka 540-6207 (JP); SAKATA, Hitoshi, Chuo-ku, Osaka 540-6207 (JP); IDE, Daisuke, Chuo-ku, osaka 540-6207 (JP)
(74) Representative: Klunker . Schmitt-Nilson . Hirsch
(86) International application number: PCT/JP2012/056120
(87) International publication number: WO 2012/132838

(57) **Abstract**

This method for producing a photoelectric conversion device has: a step for forming each of an IN layer and an IP layer on one surface of an n-type monocrystalline silicon substrate; and a step of forming an n-side electrode and a p-side electrode, each including a plurality of conductor layers. Also, the step for forming the electrodes includes: a first step for forming a first conductive layer on the IN layer and the IP layer; a second step for forming a second conductive layer on the portion of the first conductive layer that covers the IN layer, and a second conductive layer on the portion of the first conductive layer that covers the IP layer; and a third step for forming a first conductive layer and a first conductive layer by partially etching the first conductive layer after completing the second step.

## Description

### TECHNICAL FIELD

The present invention relates to a method for producing a photoelectric conversion device.

### BACKGROUND ART

Photoelectric conversion devices such as solar cells have attracted much attention as an environmentally-friendly energy source. An important issue in the photoelectric conversion device such a solar cell is how the photoelectric conversion efficiency should be increased. In view of such a situation, Patent Document 1 suggests a so-called back junction solar cell including a p-type semiconductor region and a p-side electrode and an n-type semiconductor region and an n-side electrode formed on the back surface of the solar cell. With such a back junction solar cell, in which no electrodes exist on the light-receiving surface side, the efficiency of receiving sunlight can be increased to thereby enhance the power generation efficiency.

### PRIOR ART DOCUMENT

### PATENT DOCUMENT

Patent Document 1: JP 2009-200267 A

### DISCLOSURE OF THE INVENTION

### TECHNICAL PROBLEMS

However, sufficient studies have not been performed heretofore concerning the back junction solar cells, and therefore there is room for improvement concerning an increase in the photoelectric conversion efficiency and the like. Among a plurality of matters to be improved, improvements for the structure of the electrode that collects carriers and the method for production thereof are particularly significant. For example, in the case of forming the electrode portion by plating, it is required that durability of the electrode portion be improved to thereby develop a photoelectric conversion device with higher reliability.

The present invention is made in view of the above matters, and is aimed at providing a method for producing a photoelectric conversion device, in which durability of electrodes can be improved.

### SOLUTION TO PROBLEMS

A method for producing a photoelectric conversion device according to the present invention includes the steps of forming each of a p-type region and an n-type region on one surface of a semiconductor substrate, and forming an n-side electrode and a p-side electrode, each including a plurality of conductive layers, in which the p-side electrode is formed on the p-type region and the n-side electrode is formed on the n-type region. The step of forming the electrodes includes a first step of forming a first conductive layer on the p-type region and the n-type region, a second step of forming a p-side second conductive layer on a portion of the first conductive layer that covers the p-type region and an n-side second conductive layer which is separated from the p-side second conductive layer on a portion of the first conductive layer that covers the n-type region, and a third step of partially etching the first conductive layer, after completion of the second step, to form a p-side first conductive layer under the p-side second conductive layer and an n-side first conductive layer under the n-side second conductive layer.

### ADVANTAGEOUS EFFECTS OF INVENTION

According to the method for producing a photoelectric conversion device according to the present invention, it is possible to provide a photoelectric conversion device in which durability of the electrodes can be improved to thereby further enhance the photoelectric conversion efficiency.

### BRIEF DESCRIPTION OF THE DRAWINGS

[FIG. 1] Plan view of a photoelectric conversion device according to an embodiment of the present invention seen from the back surface side.
[FIG. 2] Cross sectional view taken along A-A line in FIG. 1.
[FIG. 3] Cross sectional view for explaining a method for producing the photoelectric conversion device according to the embodiment of the present invention, which is a view illustrating a process of producing a photoelectric conversion portion.
[FIG. 4] Cross sectional view for explaining a method for producing the photoelectric conversion device according to the embodiment of the present invention, which is a view illustrating a process for producing a photoelectric conversion portion.
[FIG. 5] Cross sectional view for explaining a method for producing the photoelectric conversion device according to the embodiment of the present invention, which is a view illustrating a process for producing a photoelectric conversion portion.
[FIG. 6] Cross sectional view for explaining a method for producing the photoelectric conversion device according to the embodiment of the present invention, which is a view illustrating a process for producing a photoelectric conversion portion.
[FIG. 7] Cross sectional view for explaining a method for producing the photoelectric conversion device according to the embodiment of the present invention, which is a view illustrating a process for forming an n-side electrode and a p-side electrode.
[FIG. 8] Cross sectional view for explaining a method for producing the photoelectric conversion device according to the embodiment of the present invention, which is a view illustrating a process for forming an n-side electrode and a p-side electrode.
[FIG. 9] Cross sectional view for explaining a method for producing the photoelectric conversion device according to the embodiment of the present invention, which is a view illustrating a process for forming an n-side electrode and a p-side electrode.
[FIG. 10] Cross sectional view for explaining a method for producing the photoelectric conversion device according to the embodiment of the present invention, which is a view illustrating a process for forming an n-side electrode and a p-side electrode.
[FIG. 11] Cross sectional view for explaining a method for producing the photoelectric conversion device according to the embodiment of the present invention, which is a view illustrating a process for forming an n-side electrode and a p-side electrode.
[FIG. 12] Cross sectional view for explaining a method for producing the photoelectric conversion device according to the embodiment of the present invention, which is a view illustrating a process for forming an n-side electrode and a p-side electrode.
[FIG. 13] Cross sectional view for explaining a method for producing the photoelectric conversion device according to the embodiment of the present invention, which is a view illustrating a process for forming an n-side electrode and a p-side electrode.
[FIG. 14] Cross sectional view schematically illustrating an electrode structure which is obtained when etching of the second conductive layer and etching of the first conductive layer are performed in the same process.

### MODE FOR CARRYING OUT THE INVENTION

A preferred embodiment of the present invention will be described with reference to the drawings.

It should be noted that the following embodiment is only an example and that present invention is not limited to the following embodiment. It should also be noted that the drawings referenced in the embodiment are schematically described and a ratio of dimensions and the like of objects drawn in the drawings may be different from the ratio of dimensions of actual objects. The specific dimensional ratio or the like should be determined with reference to the following description.

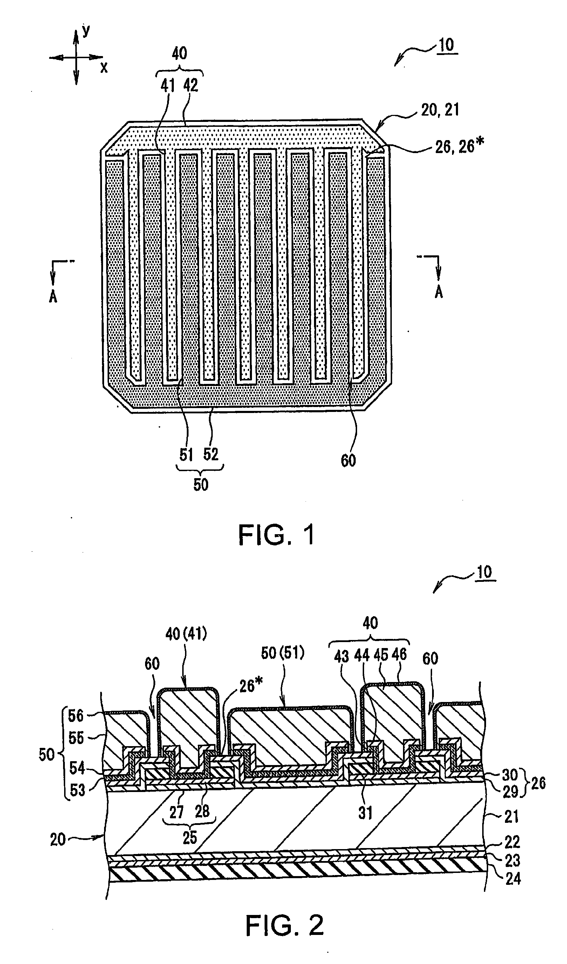

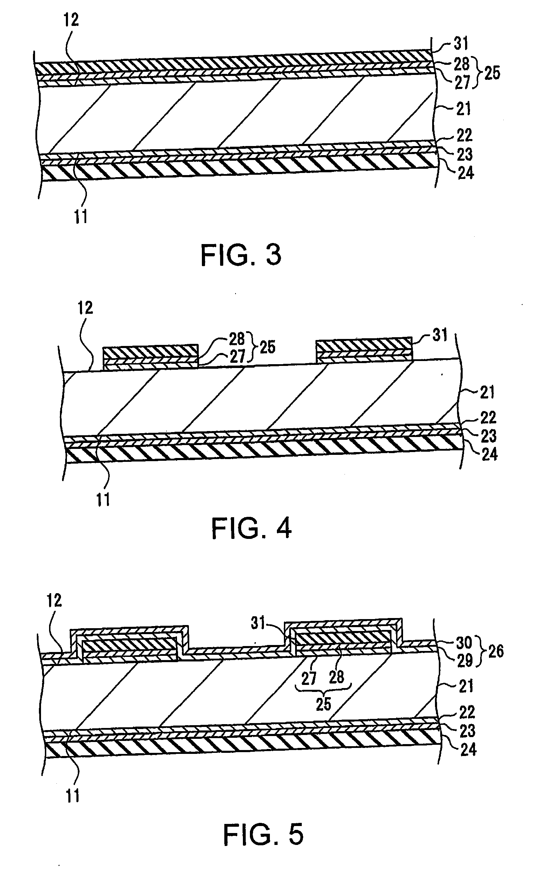

With reference to FIGs. 1 and 2, the structure of a photoelectric conversion device 10 will be described. Further, with reference to FIGs. 3 to 13, a method for producing the photoelectric conversion device 10 will be described in detail.

FIG. 1 is a plan view of a photoelectric conversion device 10 seen from the back surface side thereof. FIG. 2 is a cross sectional view taken along line A-A of FIG. 1. As illustrated in FIGs. 1 and 2, the photoelectric conversion device 10 includes a photoelectric conversion portion 20 and an n-side electrode 40 and a p-side electrode 50 that are formed on the back surface side of the photoelectric conversion portion 20. In the photoelectric conversion device 10, carriers generated in the photoelectric conversion portion 20 are collected by the n-side electrode 40 and the p-side electrode 50. Here, the "back surface" refers to a surface which is opposite a "light receiving surface" which light enters from outside the device. In other words, the back surface refers to a surface on which the n-side electrode 40 and the p-side electrode 50 are formed.

The photoelectric conversion portion 20 preferably includes an n-type monocrystalline silicon substrate 21 which is a crystal semiconductor substrate. It is preferable that, on the light receiving surface side of the monocrystalline silicon substrate 21, an i-type amorphous silicon film 22, an n-type amorphous silicon layer 23, and a protective layer 24 are sequentially laminated. Here, the i-type amorphous silicon layer 22 and the n-type amorphous silicon layer 23 function as a passivation layer. The protective layer 24 protects the passivation layer and also has an antireflection function.

The i-type amorphous silicon layer 22 and the n-type amorphous silicon layer 23 are formed in a laminate over the whole region on the light receiving surface 11 except end edge portions. The i-type amorphous silicon layer 22 is a thin film layer of intrinsic amorphous silicon, and has a thickness of 0.1 nm to 25 nm, for example. On the other hand, the n-type amorphous silicon layer 23 is a thin film layer of amorphous silicon in which phosphor (P) or the like is doped, for example, and has a thickness of 2 nm to 50 nm, for example. Further, the i-type amorphous silicon layer 22 and the n-type amorphous silicon layer 23 preferably contain hydrogen (H₂) in view of the increase in the passivation property.

The protective layer 24 is formed over the whole region on the n-type amorphous silicon layer 23. The protective layer 24 is preferably composed of a material with high light transmissivity, and silicon dioxide (SiO₂), silicon nitride (SiN), or silicon oxynitride (SiON) and the like is used, for example. In the present embodiment, an SiN layer is formed as the protective layer 24. The thickness of the protective layer 24 can be modified as appropriate in consideration of the antireflection property and so on, and is preferably about 80 nm to 1 µm, for example.

On the back surface side of the n-type monocrystalline silicon substrate 21, an IN amorphous silicon layer 25 (hereinafter referred to as an "IN layer 25") which forms an n-type region and an IP amorphous silicon layer 26 (hereinafter referred to as an "IP layer 26") which forms a p-type region are formed. The front surface of the IN layer 25 is insulated from the IP layer 26 by an insulating layer 31. The IN layer 25 and the IP layer 26 are formed directly on the back surface of the n-type monocrystalline silicon substrate 21.

In view of the photoelectric conversion efficiency and so on, the IN layer 25 and the IP layer 26 are preferably formed alternately along one direction which is parallel to the back surface, for example. It is also preferable that the IN layer 25 and the IP layer 26 are formed so as to cover a wide range on the back surface of the n-type monocrystalline silicon substrate 21. It is therefore preferable that the IN layer 25 and the IP layer 26 are formed such that one of these layers overlaps the other layer with no gap therebetween, for example, such that a part of the IN layer 25 and a part of the IP layer 26 overlap each other.

In the following description, a mode in which the IP layer 26 is formed on the IN layer 25 so as to be superposed thereon is described. Further, a region of the IP layer 26 which is formed on the IN layer 25 by superposing will be referred to as a "superposed region 26*". Also, the direction parallel to the back surface, in which the IN layer 25 and the IP layer 26 are formed alternately will be referred to the "x direction", and the direction parallel to the back surface which is orthogonal to the x direction will be referred to as the "y direction". In FIG. 1, the right-left direction on the sheet plane corresponds to the x direction, and the up-down direction on the sheet plane corresponds to the y direction.

The IN layer 25 includes an i-type amorphous silicon layer 27 formed on the back surface 12 and an n-type amorphous silicon layer 28 formed on the i-type amorphous silicon layer 27. The i-type amorphous silicon layer 27 and the n-type amorphous silicon layer 28 can be formed with the compositions and thicknesses that are similar to those of the i-type amorphous silicon layer 22 and the n-type amorphous silicon layer 23, respectively.

The insulating layer 31 is preferably formed over the whole region of the n-type amorphous silicon layer 28. The insulating layer 31 can be formed with the composition and thickness that are similar to those of the protective layer 24, for example. An SiN layer is particularly preferable as the insulating layer 31.

The IP layer 26 includes an i-type amorphous silicon layer 29 formed mainly on the back surface of the monocrystalline silicon substrate 21, and a p-type amorphous silicon layer 30 formed on the i-type amorphous silicon layer 29. The i-type amorphous silicon layer 29 can be formed with the composition and thickness that are similar to those of the i-type amorphous silicon layer 22 and the i-type amorphous silicon layer 27. The p-type amorphous silicon layer 30 is a thin film layer of amorphous silicon in which boron (B) and the like is doped, for example. The p-type amorphous silicon layer 30 preferably has a thickness of about 2 nm to 50 nm, for example.

An n-side electrode 40 is an electrode that collects carriers (electrons) from the IN layer 25 of the photoelectric conversion portion 20. On the other hand, a p-side electrode 50 is an electrode that collects carriers (hole) from the IP layer 26 of the photoelectric conversion portion 20. Each electrode includes a plurality of finger electrode portions 41, 51 and a bus bar electrode 42, 52 for connecting corresponding finger electrode portions.

Each of the n-side electrode 40 and the p-side electrode 50 is formed of a laminate which is composed of a first conductive layer 43, 53, a second conductive layer 44, 54, a third conductive layer 45, 55, and a fourth conductive layer 46, 56. The first conductive layer 43, the second conductive layer 44, the third conductive layer 45, and the fourth conductive layer 46 are n-side conductive layers, and the first conductive layer 53, the second conductive layer 54, the third conductive layer 55, and the fourth conductive layer 56 are p-side conductive layers. The first conductive layers 43 and 53 are formed of a transparent conductive layer. The second conductive layers 44 and 54 are formed of a metal layer, and copper (Cu) is used, for example, in view of electrical conductivity and material costs. The first conductive layers 43 and 53 and the second conductive layers 44 and 54 are formed by sputtering. Alternatively, the first conductive layers 43 and 53 and the second conductive layers 44 and 54 may be formed by other film-forming methods including CVD and PVD.

The transparent conductive layer is preferably formed including at least one type among metal oxides such as indium oxide (In₂O₃), zinc oxide (ZnO), tin oxide (SnO₂), titanium oxide (TiO₂), and the like, having a polycrystalline structure. A dopant such as tin (Sn), zinc (Zn), tungsten (W), antimony (Sb), titanium (Ti), aluminum (Al), cerium (Ce), gallium (Ga), and the like may be doped in the above metal oxides. For example, ITO having Sn doped in In₂O₃ is particularly preferable. The concentration of the dopant can be 0 to 20 wt%.

The metal layer preferably has a thickness of about 50 nm to 1 µm, for example. The metal layer is preferably formed of a metal having high conductivity and high light reflectivity. A metal forming the metal layer may include silver (Ag), aluminum (Al), titanium (Ti), copper (Cu), tin (Sn), nickel (Ni), and the like or an alloy including one or more of these metals. For example, it is preferable that a second conductive layer 14 is a Cu layer. The following description will be made assuming that the second conductive layer 14 is a Cu layer.

The first conductive layer 43, 53 and the second conductive layer 44, 54 function as a shield layer serving as a starting point for forming the third conductive layer 45, 55 and the fourth conductive layer 46, 56 by metal plating. The method for forming the third conductive layer 45, 55 and the fourth conductive layer 46, 56 by metal plating will be described in detail below.

The third conductive layers 45 and 55 are formed of a metal layer, and Cu (copper) is used, for example, in view of electrical conductivity and material costs. The fourth conductive layers 46 and 56 are formed of a metal layer, and Sn (tin) is used, for example, in view of prevention of corrosion of the first conductive layers 43 and 53, the second conductive layers 44 and 54, and the third conductive layers 45 and 55.

FIGs. 3 to 13 are cross sectional views illustrating production processes of the photoelectric conversion device 10. FIGs. 3 to 13 are, similar to FIG. 2, cross sections in the width direction of the finger electrode portions 41 and 51.

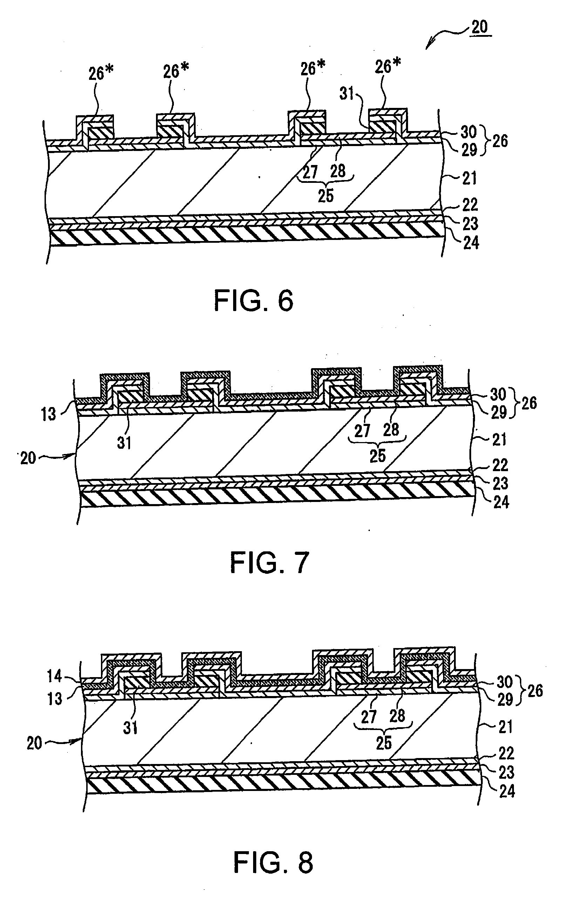

Here, FIGs. 3 to 6 illustrate production processes of the photoelectric conversion portion 20, and FIGs. 7 to 13 illustrate formation processes of the n-side electrode 40 and the p-side electrode 50.

First, with reference to FIGs. 3 to 6, the production processes of the photoelectric conversion portion 20 will be described.

As illustrated in FIG. 3, an i-type amorphous silicon layer, an n-type amorphous silicon layer, and an insulating layer (protective layer) are sequentially laminated on the light receiving surface and the back surface of a semiconductor substrate. As the semiconductor substrate, a crystalline silicon substrate, a gallium arsenide (GaAs) substrate, an indium phosphide (InP) substrate, and so on, may be applied. While the crystalline semiconductor substrate may be an n-type polycrystalline silicon substrate or a p-type monocrystalline or polycrystalline silicon substrate, in the present embodiment, the n-type monocrystalline silicon substrate 21 is used. The n-type monocrystalline silicon substrate 21 preferably has a thickness of about 100 to 300 µm.

In this process, for example, the n-type monocrystalline silicon substrate 21, which is clean, is placed in a vacuum chamber, where the respective layers are formed in a laminate structure by plasma chemical vapor deposition (PECVD) or sputtering. In the present embodiment, the i-type amorphous silicon layer 22, the n-type amorphous silicon layer 23, and the protective layer 24 are sequentially laminated on the light receiving surface 11 of the n-type monocrystalline silicon substrate 21, and the IN layer 25 and the insulating layer 31 are sequentially laminated on the back surface 12.

In the forming process of the i-type amorphous silicon layers 22 and 27, silane gas(SiH₄) is diluted with hydrogen (H₂) and this can be used as material gas, for example. Further, in the forming process of the n-type amorphous silicon layers 23 and 28, phosphine (PH₃) is added to silane gas(SiH₄) and is further diluted with hydrogen (H₂) and this can be used as material gas, for example. By varying the dilution ratio of silane gas with hydrogen, the film properties of the i-type amorphous silicon layers 22 and 27 and the n-type amorphous silicon layers 23 and 28 can be varied. Further, with a variation in the concentration of phosphine (PH₃) to be added, the doping concentration of the n-type amorphous silicon layers 23 and 28 can be varied.

It is preferable that prior to laminating the i-type amorphous silicon layer 22 and so on, a texture structure is formed on the light receiving surface 11 of the n-type monocrystalline silicon substrate 21. Here, the "texture structure" refers to an uneven structure having projections and recesses which suppresses the surface reflection and increases the light absorption quantity of the photoelectric conversion portion 20. A specific example of the texture structure can include an uneven structure having projections and recesses in a pyramid shape (a quadrangular pyramid shape or a truncated quadrangular pyramid shape) which is obtained by applying anisotropic etching to the light receiving surface having a (100) plane. The texture structure can be formed by applying anisotropic etching to the (100) plane by an aqueous solution of potassium hydroxide (KOH).

Subsequently, as illustrated in FIG. 4, each of the layers stacked on the back surface 12 are patterned. First, the insulating layer 31 is partially etched and removed. The region of the insulating layer 31 to be removed corresponds to the region on the back surface 12 on which the IP layer 26 is to be formed in the later process. During the etching process of the insulating layer 31, a resist film formed by screen printing, a coating process using ink jet, or a photolithography process, is used as a mask. When the insulating layer 31 is formed of silicon dioxide (SiO₂), silicon nitride (SiN), or silicon oxynitride (SiON), etching can be performed by using an aqueous solution of hydrogen fluoride (HF), for example.

After completion of etching of the insulating layer 31, the resist film is removed, and with the insulating film 31 which has been patterned being used as a mask, the IN layer 25 which is exposed is etched. Etching of the IN layer 25 is performed with the use of an alkaline etchant such as a sodium hydroxide (NaOH) aqueous solution (e.g. 1 wt% NaOH aqueous solution), for example. With this process, the IN layer 25 and the insulating layer 31 that are patterned are formed on the back surface 12.

For etching of the IN layer 25, the IP layer 26, and the insulating layer 31, an etching paste and an etching ink with an adjusted viscosity, for example, can also be used. In this case, an etching paste is applied by screen printing, ink jetting, and the like, to the region from which the IN layer 25 or the like are to be removed.

Subsequently, as illustrated in FIG. 5, the IP layer 26 is formed over the whole region on the back surface 12 except for the end edge regions. In other words, the IP layer 26 is formed on the patterned IN layer 25 as well via the insulating layer 31. The IP layer 26 can be formed in a predetermined pattern by using a resist process or the like. However, from the point of view of simplification of the process, it is preferable that the IP layer 26 is first formed over the whole region on the back surface 12 except for the end edge regions and is then patterned in the later process.

The IP layer 26, similarly to the IN layer 25, can be formed by sequentially forming the i-type amorphous silicon layer 29 and the p-type amorphous silicon layer 30 by PECVD. However, in the lamination process of the p-type amorphous silicon layer 30 by PECVD, diborane (B₂H₆) is used in place of phosphine (PH₃) as doping gas.

Then, as illustrated in FIG. 6, the IP layer 26 which is formed on the IN layer 25 is patterned to partially remove the insulating layer 31. In this process, first, the IP layer 26 formed on the IN layer 25 is partially removed by etching. The region of the IP layer 26 to be removed corresponds to the region on the IN layer 25 where the n-side electrode 40 is to be formed in the later process. In the etching process of the IP layer 26, with the use of a resist film formed by screen printing and the like as a mask, etching is performed by using an alkaline etchant such as an NaOH aqueous solution. In this process, the region which is protected by forming a resist film corresponds to the superposed region 26 of the IP layer 26 and the region where the IN layer 25 has been removed.

As the IP layer 26 is generally more difficult to etch than the IN layer 25, it is preferable that for etching the IP layer 26, an NaOH aqueous solution having a higher concentration (e.g. 10 wt% NaOH aqueous solution) than that used for the IN layer 25, or fluonitric acid (HF, HNO₃) (e.g. each 30 wt%) is used. Alternatively, it is also preferable that the NaOH aqueous solution is used after being heated to about 70 to 90°C (thermal-alkaline treatment).

After completion of etching of the IP layer 26, for example, the resist film is removed, and with the use of the patterned IP layer 26 as a mask, the insulating layer 31 which is exposed is removed by etching using a HF aqueous solution.

In this process, by partially removing the insulating layer 31, a part of the IN layer 25 is exposed. On the other hand, the insulating layer 31 remains unremoved over the whole region on the IN layer 25 where the IP layer 26 is formed in a superposed manner (i.e. under the superposed region 26*). With this configuration, electrical connection between the IN layer 25 and the n-side electrode 40 is enabled while securing a preferable insulating property between the IN layer 25 and the IP layer 26.

Now, with reference to FIGs. 7 to 13, processes for forming the n-side electrode 40 and the p-side electrode 50 will be described.

In the following description, processes for forming a third conductive layer 45, 55 and a fourth conductive layer 46, 56 in each electrode by electroplating with a second conductive layer 44, 54 in each electrode being used as a seed layer will be described.

As illustrated in FIG. 7, a first conductive layer 13 is formed on the IN layer 25 which is exposed and the IP layer 26 which is patterned. The first conductive layer 13 is formed over substantially the whole region on the IN layer 25 and the IP layer 26. Here, the first conductive layer 13 is a layer which will be the first conductive layer 43, 53 of each electrode by patterning in the later process.

The first conductive layer 13 is a transparent conductive layer (TCO film), for example, and can be formed by sputtering or PECVD. The first conductive layer 13 preferably has a thickness of about 50 nm to 100 nm, for example. Hereinafter, the first conductive layer 13 will be described as a transparent conductive layer (TCO film).

Subsequently, as illustrated in FIG. 8, a second conductive layer 14 is formed on the first conductive layer 13. The second conductive layer 14 is a metal layer, for example, and can be formed by sputtering or PECVD. This process is performed following the film forming process of the first conductive layer 13, and the second conductive layer 14 is formed over the whole region on the first conductive layer 13. Here, the second conductive layer 14 is a layer which will be the second conductive layer 44, 54 of each electrode by patterning in the later process.

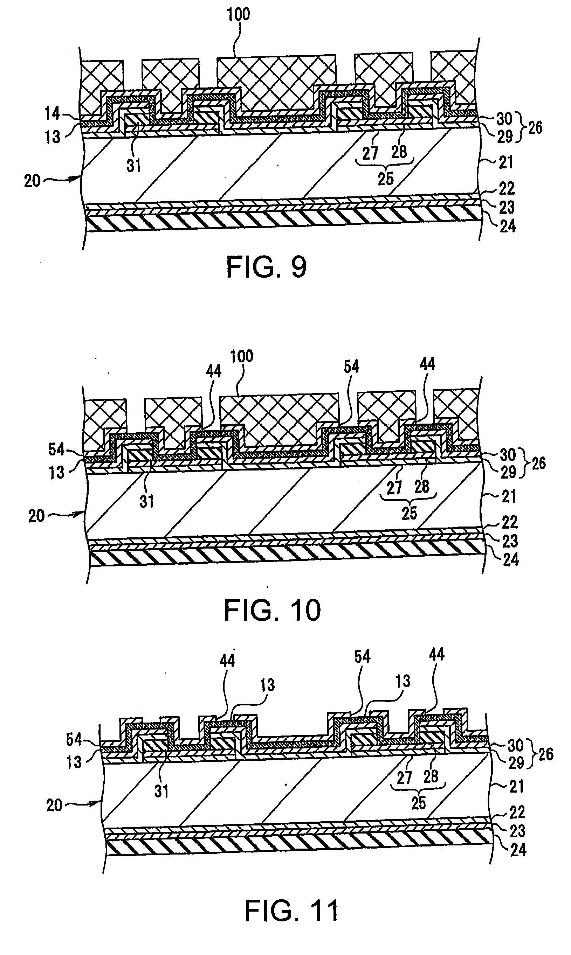

Subsequently, as illustrated in FIGs. 9 and 10, with a resist film 100 being used as a mask, for example, the second conductive layer 14 is partially etched to separate the second conductive layer 14 thereby forming second conductive layers 44 and 54 of the respective electrodes that are separated from each other. The resist film 100 can be formed by screen printing and the like, as described above. The second conductive layer 14 can be etched by using a ferric chloride (FeCl₃) aqueous solution, for example. While the etching time varies somewhat depending on the thickness of the second conductive layer 14, the etching time of about 10 to 30 seconds is preferable.

Preferably, the region of the second conductive layer 14 to be etched is a portion on a linear region along the superposed region 26*, for example. Specifically, by forming the resist film 100 over the whole region on the second conductive layer 14 such that a linear etching region along the superposed region 26* is exposed, the second conductive layers 44 and 54 of the respective electrodes that are separated from each other along the superposed region 26* are formed.

An interval between the second conductive layer 44 and the second conductive layer 54 can be controlled by adjusting the forming pattern of the resist film 100, for example. It is preferable that this interval is adjusted in consideration of the growth of the third conductive layers 45 and 55 and the fourth conductive layers 46 and 56 in the lateral direction, and is preferably about 200 µm, for example.

In place of forming the second conductive layer 14 first and patterning the second conductive layer 14 in the later process, the second conductive layers 44 and 54 can also be formed by sputtering or PECVD by using a resist process or a metal mask. It is also possible to form the second conductive layers 44 and 54 by screen printing or a coating process using ink jet.

Thereafter, as illustrated in FIG. 11, the resist film 100 is removed. With the etching of the second conductive layer 14, a part of the first conductive layer 13 which is a transparent layer is exposed. For example, while the first conductive layer 13 is exposed along the superposed region 26*, the first conductive layer 13 is not reduced under the etching conditions of the second conductive layer 14. Here, the resist film 100 may be removed after or simultaneously with etching of the first conductive layer 13.

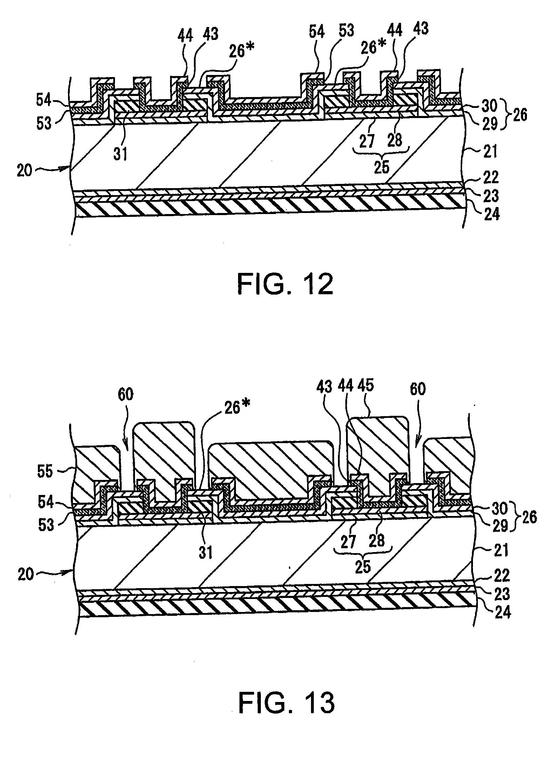

Subsequently, as illustrated in FIG. 12, with the second conductive layers 44 and 54 being used as a mask, for example, the first conductive layer 13 which is exposed is etched to separate the first conductive layer 13, thereby forming the first conductive layers 43 and 53 of the respective electrodes, that are separated from each other. The first conductive layer 13 can be etched by using a hydrogen chloride (HCl) aqueous solution or an oxalic acid aqueous solution, for example. The etching time, which varies somewhat depending on the thickness of the first conductive layer 13, is preferably about 5 to 15 minutes.

In this process, etching of the first conductive layer 13 is performed under the conditions that the second conductive layers 44 and 54 are not etched, i.e. by using an etchant that does not contain ferric chloride, for example. As the first conductive layer 13 which is exposed is etched with the second conductive layers 44 and 54 being used as a mask, an interval between the first conductive layer 43 and the first conductive layer 53 is equal to the interval between the second conductive layer 44 and the second conductive layer 54. The region of the first conductive layer 13 which is etched is a region immediately above the superposed region 26*, for example, and is a linear region along the superposed region 26*.

Thereafter, as illustrated in FIG. 13, third conductive layers 45 and 55 are formed on the second conductive layers 44 and 54, respectively. It is preferable that the third conductive layers 45 and 55 are formed by electroplating with the second conductive layers 44 and 54 being used as seed layers, respectively. Further, it is preferable that fourth conductive layers 46 and 56 are formed by electroplating on the third conductive layers 45 and 55, respectively. In this manner, the photoelectric conversion device 10 (see FIG. 2) in which the n-side electrode 40 and the p-side electrode 50 are formed can be obtained on the back surface side of the photoelectric conversion portion 20.

The third conductive layers 45 and 55 are preferably Cu layers similar to the second conductive layers 44 and 54, for example. The fourth conductive layers 46 and 56 function as protective layers that prevent oxidation of the Cu layers to thereby prevent a reduction in conductivity, and are preferably Sn layers, for example. The thickness of the Cu layer is preferably about 10 µm to 20 µm, for example, and the thickness of the Sn layer is preferably about 1 µm to 5 µm.

Electroplating can be performed by causing electric current of the same magnitude to flow in the second conductive layer 44 forming the n-side electrode 40 and the second conductive electrode layer 54 forming the p-side electrode 50. In this case, metal plating layers having the same mass are formed on the second conductive layers 44 and 54, respectively. Therefore, in the n-side electrode 40 having a smaller laminate area than that in the p-side electrode 50, the thickness of the third conductive layer is greater. In other words, by performing electroplating by causing electric current with the same magnitude to flow in the n-side electrode 40 and the p-side electrode 50, the thickness of the n-side electrode 40 can be made greater than the thickness of the p-side electrode 50. In this electroplating process, the third conductive layers 45 and 55 grow not only in the thickness direction but also in the lateral direction.

As described above, in the production process according to the present embodiment, after completion of the patterning process of the second conductive layer 14, the etching process of the first conductive layer 13, which is independent of the patterning process of the second conductive layer 14, is performed. Consequently, as illustrated in FIG. 2, the interval between the first conductive layer 43 and the first conductive layer 53 is equal to the interval between the second conductive layer 44 and the second conductive layer 54. More specifically, it is possible to prevent over-etching of the second conductive layers 44 and 54 in the lateral direction which occurs when etching of the second conductive layer 14 and etching of the first conductive layer 13 are performed in the same process, so that it is possible to prevent the first conductive layers 43 and 53 from exposing from the second conductive layers 44 and 54, respectively.

On the other hand, it can also considered to perform etching of the second conductive layer 14 and etching of the first conductive layer 13 in a single process by using an aqueous solution containing FeCl₃ and HCl. In this case, however, during etching of the first conductive layer 13 which is a transparent conductive layer, the second conductive layer 14 which is a Cu layer is over-etched in the lateral direction. This is because the etching time for the Cu layer is short, such as 10 seconds, whereas the etching time for the transparent conductive layer is long, such as 10 minutes.

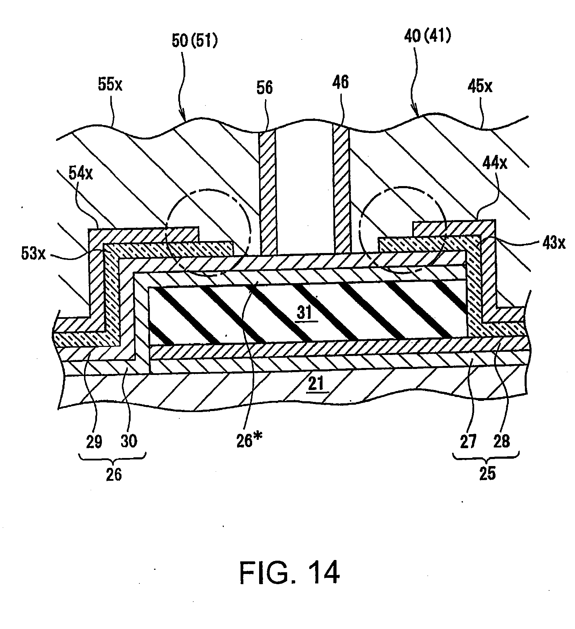

FIG. 14 is a cross sectional view schematically illustrating an electrode structure obtained when etching of the second conductive layer 14 and etching of the first conductive layer 13 are performed in the same process by using an aqueous solution containing FeCl₃ and HCl. In the electrode structure illustrated in FIG. 14, in which the third conductive layers 45x and 55x which are Cu plating layers have also grown on the first conductive layers 43x and 53x that are transparent layers exposed from the second conductive layers 44x and 54x, the adhesion property between the transparent layer and the Cu plating layer is inferior to the adhesion property between the Cu seed layer and the Cu plating layer and is not considered to be preferable. For example, the Cu plating layer on the conductive layer is easier to remove than the Cu plating layer on the Cu seed layer.

With the production process according to the present embodiment, it is possible to prevent the Cu plating layer from growing on the transparent conductive layer. Consequently, the durability of electrodes can be enhanced so that a photoelectric conversion device with higher reliability can be obtained. Also, it is possible to provide a photoelectric conversion device in which the durability of an electrode can be enhanced to thereby further increase the photoelectric conversion efficiency.

In the present embodiment, design modifications can be made within a scope in which the object of the present invention is implemented.

For example, while in the above example, the IN layer 25 is first formed and then IP layer 26 is formed, the IP layer 26 may be formed first. In this case, it is preferable to provide a structure in which a part of the IN layer 25 is superposed on a part of the IP layer 26.

Further, while in the above example, the IN layer 25 and the IP layer 26 are formed on the back surface 12 of the n-type monocrystalline silicon substrate 21 in a comb teeth pattern in which the IN layer 25 and the IP layer 26 engage with each other, for example, to thereby form the n-type region and the p-type region, each of these regions may be formed by causing a dopant to diffuse thermally. For example, it is possible to cause an n-type dopant to thermally diffuse in one region on the back surface 12 to thereby form a highly-doped n-type region and to thermally diffuse in another region to thereby form a p-type region.

### REFERENCE SYMBOLS LIST

10 photoelectric conversion device, 11 light receiving surface, 12 back surface, 13 first conductive layer, 14 second conductive layer, 20 photoelectric conversion portion, 21 n-type monocrystalline silicon substrate, 22, 27, 29 i-type amorphous silicon layer, 23, 28 n-type amorphous silicon layer, 24 protective layer, 25 IN amorphous silicon layer (IN layer), 26 IP amorphous silicon layer (IP layer), 30 p-type amorphous silicon layer, 31 insulating layer, 40 n-side electrode, 41, 51 finger electrode portion, 42, 52 bus bar electrode portion, 43, 53 first conductive layer, 44, 54 second conductive layer, 45, 55 third conductive layer, 46, 56 fourth conductive layer, 50 p-side electrode, 60 separation groove.

## Claims

1. A method for producing a photoelectric conversion device, the method comprising the steps of:
forming each of a p-type region and an n-type region on one surface of a semiconductor substrate; and
forming an n-side electrode and a p-side electrode, each including a plurality of conductive layers, the p-side electrode being formed on the p-type region and the n-side electrode being formed on the n-type region;
wherein
the step of forming the electrodes includes:
a first step of forming a first conductive layer on the p-type region and the n-type region;
a second step of forming a p-side second conductive layer on a portion of the first conductive layer that covers the p-type region and an n-side second conductive layer which is separated from the p-side second conductive layer on a portion of the first conductive layer that covers the n-type region; and
a third step of partially etching the first conductive layer with the p-side second conductive layer and the n-side second conductive layer being used as a mask.

2. The method for producing a photoelectric conversion device according to Claim 1, wherein
the second step comprises forming a second conductive layer that covers the first conductive layer, and partially etching the second conductive layer to form the p-side second conductive layer and the n-side second conductive layer.

3. The method for producing a photoelectric conversion device according to Claim 1 or 2, wherein
the second step comprises forming the p-side second conductive layer and the n-side second conductive layer, respectively, by a printing method or a mask deposition method.

4. The method for producing a photoelectric conversion device according to any one of Claims 1 to 3, further comprising a step of forming, after completion of the third step, a p-side third conductive layer and an n-side third conductive layer by electroplating in which electric current is caused to flow in the p-side second conductive layer and the n-side second conductive layer, respectively.

5. The method for producing a photoelectric conversion device according to Claim 4, wherein
the first conductive layer is a transparent conductive layer, and
each of the second conductive layers and each of the third conductive layers are metal layers.

6. The method for producing a photoelectric conversion device according to any one of Claim 1 to 5, wherein
the semiconductor substrate is a crystalline semiconductor substrate; and
the p-type region and the n-type region are formed by a p-type amorphous semiconductor and an n-type amorphous semiconductor, respectively.
